# EUROPEAN PATENT APPLICATION

(11) **EP 4 687 396 A1**
(43) Date of publication of application: **04.02.2026**
(21) Application number: 24192360.6
(22) Date of filing: 01.08.2024
(51) Int. Cl.: H10D 62/10, H10D 12/00, H10D 62/13

(54) **SEMICONDUCTOR DEVICE**

(71) Applicant: Hitachi Energy Ltd, 8050 Zürich (CH)
(72) Inventor: Buitrago, Elizabeth, 5210 Windisch (CH); De Michielis, Luca, 5000 Aarau (CH); Boksteen, Boni Kofi, 5600 Lenzburg (CH)
(74) Representative: Epping - Hermann - Fischer

(57) **Abstract**

In one embodiment of the semiconductor device (1)
- at an emitter side (3), a semiconductor layer sequence (2) comprises a plurality of source regions (31) and a plurality of well regions (32), each of the source regions (31) is embedded in one of the well regions (32),
- at a collector side (4), the semiconductor layer sequence (2) comprises a pilot region (41) which is uniformly of a same conductivity type and a mixed region (42) which is of of two conductivity types and which surrounds the pilot region (41), and
- a first area occupancy of the emitter side (3) by the source regions (31) is larger in the pilot region (41) than in the mixed region (42) and/or a second area occupancy of the well regions (32) by the source regions (31) is smaller in the pilot region (41) than in the mixed region (42).

## Description

A semiconductor device is provided.

Documents EP 2 249 392 A2 and WO 2015/097157 A1 refer to Bi-mode Insulated Gate Transistors, BiGTs.

A problem to be solved is to provide a semiconductor device that has improved electrical properties.

This object is achieved, inter alia, by a semiconductor device as defined in the independent claim. Exemplary further developments constitute the subject-matter of the dependent claims.

For example, the semiconductor device described herein comprises a plurality of source regions at an emitter side embedded in well regions. At a collector side, there is a pilot region and a mixed region. A first area occupancy of the emitter side by the source regions is larger in the pilot region than in the mixed region.

Reverse conducting insulated gate bipolar transistors, RC-IGBTs, can be used in high-power applications for increased power densities, electrical and thermal performance. Though attractive for its potential full utilization of the silicon area, the use of the same chip for both IGBT and diode operational modes presents different limitations, challenges and opportunities in comparison to a two-chip diode/IGBT solution.

For example, a bi-mode insulated gate transistor, BiGT, a type of RC-IGBT, includes a large, central, and uninterrupted p-doped backside anode region dedicated for IGBT conduction called pilot-IGBT. It also includes a mixed region of distributed n-doped cathode shorts and p-doped areas surrounding the pilot-IGBT, for example, optimized to reduce secondary snapback events and improve the thermal and safe operation area, SOA, performance of the device.

In the device described herein, an optimization of active cell design parameters, like an n-source ratio and a pitch, as a function of their position with respect to regions defined by the backside design, that is, the pilot-IGBT and the shorts in the mixed region of a BiGT is enabled. It is therefore possible to improve the IGBT and diode performance of the device separately and where it matters most. The area above the pilot region can be optimized for IGBT performance which has almost no influence in diode performance as it sits above the pilot area, independently of the area above the mixed region that would ideally be optimized for diode performance.

In other implementations of BiGT devices, a uniform n-source ratio and/or cell pitch is exclusively used in the entire active area regardless of the backside design and function. With the semiconductor device described herein, it is possible to separately improve the IGBT and diode performance of the BiGT semiconductor by optimizing the active cell parameters, like n-source ratio and cell pitch, by taking into consideration their position with respect to regions defined by the backside design, namely pilot and mixed region. In this way, the reverse bias safe operating area, RBSOA, and the short circuit safe operating area, SCSOA, performance can be improved without losing on-state performance and better control of IGBT vs. diode performance trade-offs can be achieved and an extra level of optimization is given.

Thus, powerful optimization/trade-off knobs for different applications are implemented, and improved RBSOA/SCSOA without losing on-state performance and better control of the IGBT vs. diode performance trade-offs are enabled.

According to at least one embodiment, the semiconductor device comprises a semiconductor layer sequence. The semiconductor layer sequence may include a substrate on which further semiconductor layers are grown. Doping may be realized, for example, by growth conditions and/or by implanting dopants. For example, the semiconductor layer sequence is of silicon, Si. However, the semiconductor layer sequence can alternatively be of a wide-bandgap semiconductor material like SiC, Ga₂O₃ or GaN as well.

According to at least one embodiment, the semiconductor layer sequence has an emitter side and a collector side. The collector side is opposite the emitter side. The emitter side and the collector side can be main sides, that is, largest sides, of the semiconductor layer sequence. For example, a gate electrode of the semiconductor device is located at the emitter side.

According to at least one embodiment, at the emitter side the semiconductor layer sequence comprises a plurality of source regions. The source regions are of a first conductivity type, like n-conductive. For example, the source regions are highly doped, also referred to as n⁺-doped or n⁺⁺-doped.

According to at least one embodiment, at the emitter side the semiconductor layer sequence comprises a plurality of well regions. The well regions are of a second conductivity type different from the first conductivity type. For example, the well regions are p-conductive. The well regions may moderately be doped, referred to as p-doped.

According to at least one embodiment, each of the source regions is embedded in one of the well regions. It is possible that there is a plurality of the source regions per well region. It is further possible that there are differently designed well regions, for example, having different numbers of source regions.

According to at least one embodiment, at the collector side the semiconductor layer sequence comprises a pilot region. The pilot region is uniformly of the second conductivity type. For example, the pilot region is heavily doped, also referred to as p⁺-doped or p⁺⁺-doped.

According to at least one embodiment, at the collector side the semiconductor layer sequence comprises a mixed region. The mixed region comprises first sub-regions of the first conductivity type and second sub-regions of the second conductivity type. The sub-regions may heavily be doped. Thus, for example, the first sub-regions may be n⁺-doped or n⁺⁺-doped and the second sub-regions may be p⁺-doped or p⁺⁺-doped. Especially, the second sub-regions and the pilot regions can be doped in the same manner.

According to at least one embodiment, the mixed region partially or completely surrounds the pilot region, especially seen in top view of the collector side. Thus, the mixed region may be all around the pilot region, seen in top view.

According to at least one embodiment, a first area occupancy of the emitter side by the source regions is larger in the pilot region than in the mixed region or is the same in the pilot region and in the mixed region. In other words, the percentage of the emitter side made of the source regions can be larger in the pilot regions than in the mixed region. Thus, per area unit, there is more of the source regions in the pilot region than in the mixed region, seen in top view.

Alternatively or additionally, a second area occupancy of the well regions by the source regions is smaller in the mixed region than in the pilot region. In other words, the percentage of the well regions covered by the source regions can be smaller in the mixed region than in the pilot region. For example, the difference between said percentages. Thus, per area unit, there is more of the source regions on top of the well regions in the pilot region than in the mixed region, seen in top view.

In at least one embodiment, the semiconductor device comprises a semiconductor layer sequence having an emitter side and a collector side, wherein
- at the emitter side, the semiconductor layer sequence comprises a plurality of source regions of a first conductivity type and a plurality of well regions of a second conductivity type different from the first conductivity type, each of the source regions is embedded in one of the well regions,
- at the collector side, the semiconductor layer sequence comprises a pilot region which is uniformly of the second conductivity type and a mixed region which comprises first sub-regions of the first conductivity type and second sub-regions of the second conductivity type and which surrounds the pilot region, and
- a first area occupancy of the emitter side by the source regions is larger in the pilot region than or is the same as in the mixed region and/or a second area occupancy of the well regions by the source regions is smaller in the mixed region than or is the same in the pilot region.

With this configuration of the source regions, with relatively less source region proportion in the mixed region than in the pilot region, improved RBSOA and SCSOA can be achieved and the IGBT and diode modes can be optimized more independently of one another.

According to at least one embodiment, the semiconductor device is a bi-mode insulated gate transistor, BiGT.

According to at least one embodiment, a pitch between adjacent ones of the source regions is larger in the pilot region than in the mixed region, seen in top view of the emitter side. For example, there is a first pitch P1 in the pilot region and a second pitch P2 in the mixed region, seen in top view, and P1 > P2. For example, 1.2 ≤ P1/P2 ≤ 10 or 1.3 ≤ P1/P2 ≤ 5 or 1.6 ≤ P1/P2 ≤ 4. It is possible that there are more than two different pitches. For example, a third pitch could be present in an edge region surrounding both the pilot region and the mixed region.

For example, the pitch is a distance between said adjacent ones of the source regions. It is also possible that the above applies for a grid dimension, that is, for half a width of the respective two adjacent source regions plus the pitch.

According to at least one embodiment, the emitter side comprises a pattern composed of a repeatedly placed unit cell. The unit cell comprises one or also a plurality of the source regions. It is possible that there is a first unit cell for the pilot region and a second unit cell for the mixed region, seen in top view. The first and second unit cells may have a same size or a different size. Optionally, there can be a third unit cell for an edge region of the semiconductor device. It is possible that there are exact to unit cells, that is, the first and the second unit cells.

According to at least one embodiment, an occupancy proportion of the source regions in the unit cell is larger in the pilot region than in the mixed region, seen in top view of the emitter side. In other words, in the first unit cell the proportion of the source regions is larger than in the second unit cell.

According to at least one embodiment, the pitch and/or the occupancy proportion differ between the pilot region and the mixed region by at least a factor of 1.1 or by at least a factor of 1.2 or by at least a factor of 1.4. Alternatively or additionally, said difference is at most a factor of 20 or is at most a factor of 10 or is at most a factor of 5 or is at most a factor of 2. For example, said factor is between 1.4 and 2 or is between 1.2 and 5.

According to at least one embodiment, some or all of the source regions are arranged along one or a plurality of arrangement lines, seen in top view of the emitter side. For example, in case of a plurality of arrangement lines, the arrangement lines are straight lines. It is possible that all the arrangement lines or some of the arrangement lines run in parallel with each other. Otherwise, the arrangement lines may be curved and/or kinked. For example, the arrangement lines are lines at which one continuous well region and/or plug region is exposed from a gate electrode and a gate insulation at the emitter side. Thus, the arrangement lines may be continuous areas of the emitter side being in direct contact with a first electrode, like an emitter electrode, for example. Hence, there may be exactly one continuous area of contact between the first electrode and the semiconductor layer sequence per arrangement line. Further, there may be at least two or at least five source regions per arrangement line, seen along the arrangement line, for example.

According to at least one embodiment, the unit cell includes a portion of one or of a plurality of the arrangement lines. For example, the unit cell includes one or two of the arrangement lines. Thus, the arrangement lines can define a pattern of the source regions, of the well regions and/or of plug regions at the emitter side. This may apply for the first and the second unit cell.

According to at least one embodiment, if the source regions are arranged along a plurality of the arrangement lines and seen in top view of the emitter side, in the mixed region the source regions are placed at different locations along adjacent ones of the arrangement lines. Thus, for example, in case of the respective arrangement lines running in parallel seen in top view of the emitter side, a straight line running perpendicular to the arrangement lines and crossing a first one of the arrangement lines at a source region, said straight line may cross the adjacent arrangement lines out of any source region. Put in other words, along adjacent arrangement lines the source regions may be offset from each other and, thus, could be displaced.

According to at least one embodiment, the emitter side is structured into a plurality of emitter cells each comprising one or a plurality of the source regions. For example, there is exactly one source region per emitter cell. Thus, there may be no arrangement lines as defined above.

By way of example, seen in top view of the emitter side, the emitter cells may be of round shape, like elliptic or circular, or may be of polygonal shape, like hexagonal or trigonal or square or rectangular. All the emitter cells in the pilot region and in the mixed region, respectively, can be of the same design or emitter cells of different design can be combined with each other in the pilot region and in the mixed region, respectively.

According to at least one embodiment, the emitter cells correspond to the unit cell. That is, each one of the emitter cells has the design of the respective unit cell. This may apply for the first and second unit cells, for example.

According to at least one embodiment, in the pilot region and in the mixed region the pitch between adjacent ones of the source regions is the same, and in the pilot region the occupancy proportion of the source regions is larger than in the mixed region. This may apply both for a semiconductor device of the arrangement lines design and of the emitter cells design. Thus, only the occupancy proportion may differ between the mixed region and the pilot region and not the pitch.

According to at least one embodiment, in the pilot region the pitch between adjacent ones of the source regions is by at least a factor of 1.2 or by at least a factor of 1.9 larger than in the mixed region, and in the pilot region the occupancy proportion of the source regions is larger than in the mixed region by at least a factor of 1.2 or by at least a factor of 1.9. This may apply both for a semiconductor device of the arrangement lines design and of the emitter cells design. Thus, both the pitch and the occupancy proportion may differ from one another in the pilot region and in the mixed region wherein the increased pitch in the pilot region is compensated for by a decreased occupancy proportion in the mixed region.

According to at least one embodiment, the semiconductor device is of a planar design. Hence, a gate electrode of the semiconductor device is located on the emitter side and may thus not run into the semiconductor layer sequence. For an emitter electrode it is possible to run into the semiconductor layer sequence just to electrically contact the well region.

According to at least one embodiment, the semiconductor device is of a trench design. Hence, a gate electrode of the semiconductor device is partially or completely arranged in trenches extending from the emitter side into the semiconductor layer sequence, for example, seen in cross-section perpendicular to the emitter side. The trenches may terminate distant from the pilot region and the mixed region and, thus, distant from the collector side.

According to at least one embodiment, seen in top view of the emitter side, in the mixed region there is no fixed correlation between the source regions and the first sub-regions and/or the second sub-regions. For example, the second unit cell is not an integer multiple of a collector side unit cell of a design of the first and second sub-regions, and vice versa. In other words, there are not just one or two lateral offsets between the source regions and the first sub-regions, for example, seen in top view of the semiconductor layer sequence. Hence, the source regions and the first sub-regions may be placed relative to one another in a uniform distribution, for example, with the lateral offsets as a parameter to define the distribution.

According to at least one embodiment, the semiconductor device is configured for a voltage between the emitter side and the collector side of at least 0.6 kV or of at least 1.2 kV or of at least 3 kV. Alternatively or additionally, said voltage is at most 10 kV or is at most 7 kV. Hence, for example, the respective layer thicknesses of gate insulations, drift regions, well regions and so on are configured to withstand said voltage.

Alternatively or additionally, the semiconductor device is configured for a current between the source electrode and a collector electrode of at least 0.01 kA or of at least 0.1 kA of at least 1 kA and/or of at most 100 kA or of at most 10 kA.

A semiconductor device described herein is explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
- Figure 1: is a schematic cross-sectional view of an exemplary embodiment of a semiconductor device described herein,
- Figure 2: is a schematic bottom view on a collector side of the semiconductor device of Figure 1,
- Figure 3: is a schematic top view on an emitter side of the semiconductor device of Figure 1,
- Figure 4: is a schematic top view of a modified semiconductor device,
- Figures 5 to 14: are schematic top view on emitter sides in the pilot region and in the mixed region, respectively, of exemplary embodiments of semiconductor devices described herein.
- Figure 15: is a schematic cross-sectional view of an exemplary embodiment of a semiconductor device described herein.

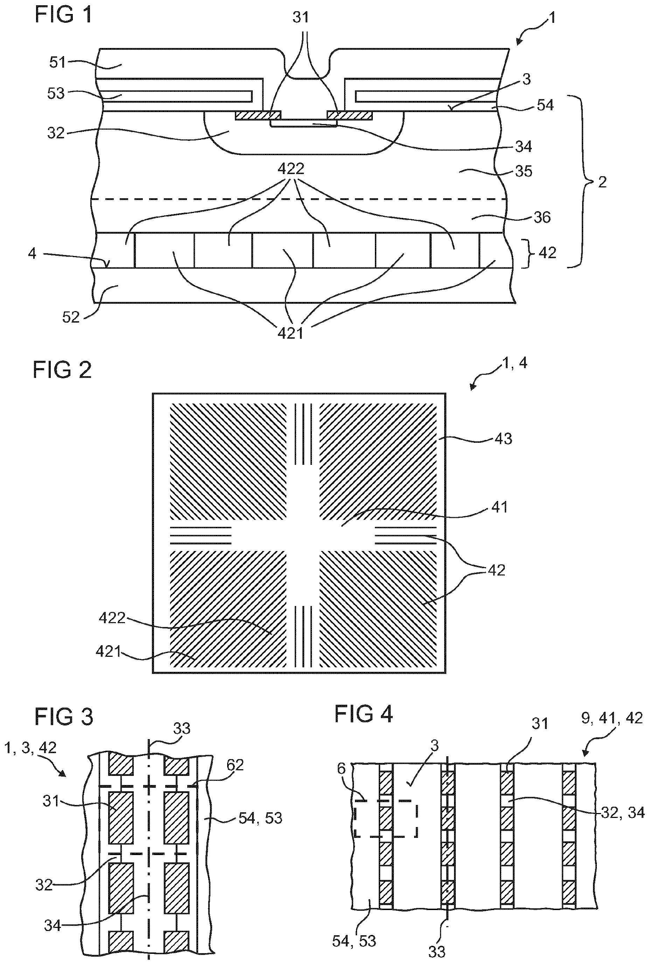

Figure 1 illustrates an exemplary embodiment of a semiconductor device 1. The semiconductor device 1 comprises a semiconductor layer sequence 2 with an emitter side 3 and a collector side 4 being based on silicon, for example. At the emitter side 3, there is a first electrode 51 which is an emitter electrode. Correspondingly, at the collector side 4 there is a second electrode 52 which is a collector electrode. Further, at the emitter side 3 there is a gate electrode 53 separated from the first electrode 51 and the semiconductor layer sequence 2 by a gate insulation 54, like a gate oxide. The first electrode 51 may completely or mostly cover the emitter side and the gate electrode 53, for example.

The semiconductor layer sequence 2 includes source regions 31 at the emitter side 4. The source regions 31 are n-conductive, for example, and are embedded in a well region 32 which is p-conductive. To electrically fix the well region 32 at an electric potential of the first electrode 51, there is optionally a p-conductive plug region 34 to connect the first electrode 51 and the well region 32. A largest part of the semiconductor layer sequence 2 is made of a drift region 35 which is n-conductive. Optionally, on a side of the drift region 35 next to the collector side 4 there can be a buffer region 36 being n-conductive, for example.

At the collector side 4, the semiconductor layer sequence 2 has a centrally arranged pilot region 41 and a circumferential mixed region 42, see also Figure 2. In the pilot region 41, the semiconductor layer sequence 2 is uniformly p-conductive next to the second electrode 52. In the mixed region 42, there are n-conductive first sub-regions 421 and p-conductive second sub-regions 422. Optionally, there is an edge region 43 all around the mixed region 42. It is possible that the edge region 43 is p-conductive.

In Figure 3 it can be seen that along an arrangement line 33 which is a straight line the source regions 31 are arranged in pairs. Thus, a unit cell 62 by which the design of the source regions 31 can be defined includes two of the source regions 31.

Figures 1 and 3 refer to a sectional view and a top view of the mixed region 42 only, respectively. However, the same applies analogously for the pilot region 41..

It is possible that the semiconductor device 1 is a reverse conducting insulated gate bipolar transistor, RC-IGBT for short, and may thus be referred to as a bi-mode insulated gate transistor, BiGT for short. Concerning details on the doping levels, dimensions of the respective regions, variation possibilities of the pattern of the mixed region 42 and the pilot region 41, reference is made to documents EP 2 249 392 A2 and WO 2015/097157 A1, the disclosure content of which is hereby included by reference.

In Figure 4, the emitter side 3 of a modified semiconductor device 9 is illustrated. In this device 9, all over the pilot region 41 and the mixed region 42 there is a same unit cell 6 so that the source regions 31 are distributed in a constant pattern all across the emitter side 3.

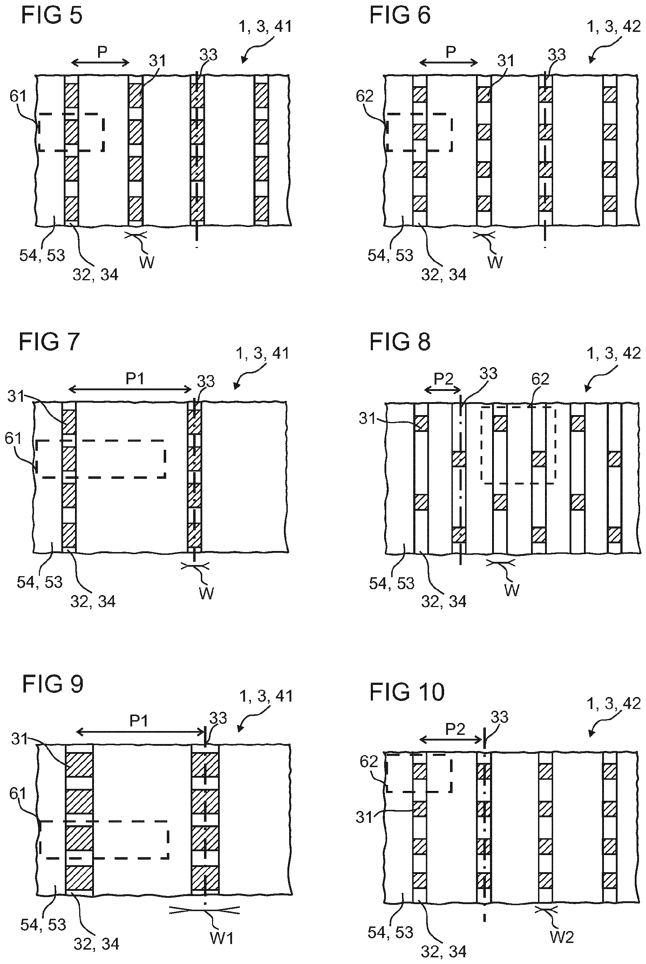

Contrary to that, in the semiconductor device 1 described herein there are different patterns of the source regions 31 and, thus, of the well regions 32 and/or the plug regions 34 in the pilot region 41 and in the mixed region 42, respectively, as illustrated below in connection with Figures 5 to 14. Not shown herein, in the edge region 43 there may be another pattern of the source regions 31, the well regions 32 and/or the plug regions 34.

In the semiconductor device 1 of Figures 5 and 6, seen in top view, both in the pilot region 41 and in the mixed region 42 the arrangement lines 33 have a same pitch P at the emitter side 3. It is also possible that the areas along the arrangement lines 33 have a same width W in both regions 41, 42. Thus, the difference between the regions 41, 42 is an occupancy proportion of the source regions 31 along the arrangement lines 33.

For example, the occupancy proportion of the source regions 31 at the emitter side assigned to the pilot region 41 is about 0.8 in a first unit cell 61, and the occupancy proportion assigned to the mixed region 42 is about 0.2 in a second unit cell 62. These values of, for example, 0.8 and 0.2 may refer to a proportion of the source regions 31 on an overall area in which the first electrode 51 touches the emitter side 3 along the respective arrangement line 33. As each unit cell 61, 62 include exactly one of the source regions 31 and as the pitch P is the same in the regions 61, 62, the first unit cell 61 may have the same size and shape as the unit cell 62.

By way of example, the width W of the areas along the arrangement lines 33 including the source regions 31 is at least 1 µm and/or at most 20 µm, for example, is between 2 µm and 15 µm. The pitch P as drawn in the Figures is a distance between adjacent ones of the arrangement lines 33, that is, from middle to middle of the lines exposed from the gate insulation 54 and the gate electrode 53. For example, the pitch P is at least 5 µm or is at least 10 µm and/or is at most 200 µm or is at most 100 µm. A distance between adjacent ones of the source regions 31 along the arrangement lines 33 is, for example, at least 1 µm and/or at most 20 µm, especially between 2 µm and 15 µm.

It is noted that in Figures 5 and 6 there is just one source region 31 at a same position along the arrangement lines 33, and not two source regions 31 as shown in Figure 3. However, the statements above to Figures 5 and 6 apply analogously to the situation shown in Figure 3. The same is true for all other embodiments.

Thus, there is a high n-source ratio in an area corresponding to the backside pilot region 41 and low n-source ratio in the area corresponding to backside mixed region 42.

With the high n-source ratio at the emitter side 3 in areas corresponding to the pilot region 41 at the collector side 4, good IGBT performance can be achieved while there is no strong impact on the diode mode as this design of the source regions 31 is limited to above the pilot region 41. With the low n-source ratio at the emitter side 3 in areas corresponding to the mixed region 42 at the collector side 4, good diode performance can be achieved due to less n-source proportion. Thus, improved overall balance is enabled to have the total amount of n-source required in the respective area.

Otherwise, the same as to Figures 1 to 3 may also apply to Figures 5 and 6, and vice versa.

In the semiconductor device 1 of Figures 7 and 8 it is shown that in the pilot region 41 the pitch P1 is increased compared to the pitch P2 in the mixed region 42. For example, the pitches P1, P2 differ by at least a factor of 1.5 and by at most a factor of 5, like a factor of 3. That is, compared with Figures 5 and 6, the pitch P1 is increased and the pitch P2 is decreased, compared with the pitch P. However, in both regions 41, 42 the areas along the arrangement lines 33 may have the same width W.

For example, as shown in Figures 7 and 8 the first pitch P1 is 100 µm and the corresponding occupancy proportion is 0.8, seen along the arrangement lines 33, and the second pitch P2 is 40 µm with an occupancy proportion of 0.2.

As an option, along the arrangement lines 33 the source regions 31 may be displaced so that, for example, at every second or, other than shown, alternatively at every third or fourth arrangement line 33 the source regions 31 are at a same position.

Thus, the first unit cell 61 may have a different size and a different shape compared with the second unit cell 62. For example, the second unit cell 62 is narrower and higher than the first unit cell 61.

By having a relatively large first pitch P1 in the pilot region, a number of electric contacts in the pilot region 41 can be decreased which can simplify the electric wiring.

Accordingly, there is a high n-source ratio and a large cell pitch P1 in the area corresponding to backside pilot region 41 and a low n-source ratio and a small cell pitch P2 in the area corresponding to the backside mixed region 42.

In Figures 7 and 8 it is exemplarily drawn that the areas along the arrangement lines 33 and the source regions 31 both have the width W. However, it is also possible that a width of the source regions 31 is smaller than the width W, that is, the areas along the arrangement lines 33 can be wider than the source regions 31. For example, the width of the source regions 31 is at least 0.7 W and/or is at most 0.9 W. Further, it is possible that the areas along the arrangement lines 33 are at places, especially between adjacent source regions 31, narrower than the source regions 31 themselves, for example, with an intermediate width Wi > 0, like 0.1 W ≤ Wi ≤ 0.6 W, or alternatively Wi = 0 is possible. The same applies analogously for all other embodiments, especially for the widths W1 and/or W2 of Figures 9 and 10 below.

Otherwise, the same as to Figures 1 to 6 may also apply to Figures 7 and 8, and vice versa.

In the semiconductor device 1 of Figures 9 and 10, the width W1, W2 of the areas along the arrangement lines 33 is varied as a further parameter. That is, in the pilot region 41, see Figure 9, the source regions 31 are broader and have the width W1 and the pitch P1 is increased so that the source regions 31 are narrower with the width W2 at a smaller pitch P2 in the mixed region 42. The width W can be varied in the embodiments of Figures 5 and 6 as well as of Figures 7 and 8 analogously.

These embodiments and implementations of Figures 7 to 10 with high n-source and large cell pitches located in the area corresponding to the pilot region 41 is good for IGBT mode and low on-states and has no strong impact on the diode mode.

The mixed region 42 can be optimized for a good diode performance with low n-source ratio to achieve a high on-state for good balance and small cell pitches P2. In other words, regions with a diode on the back, that is, the n shorts 421 of the mixed region 42, should have more p-doped areas or high channel or p-well doping for good diode performance together optimized with the corresponding pilot area with more n-source ratio optimized with the best pitch P1 for IGBT performance, that is, largest possible pitch, which would likely be limited by SOA.

Otherwise, the same as to Figures 1 to 8 may also apply to Figures 9 and 10, and vice versa.

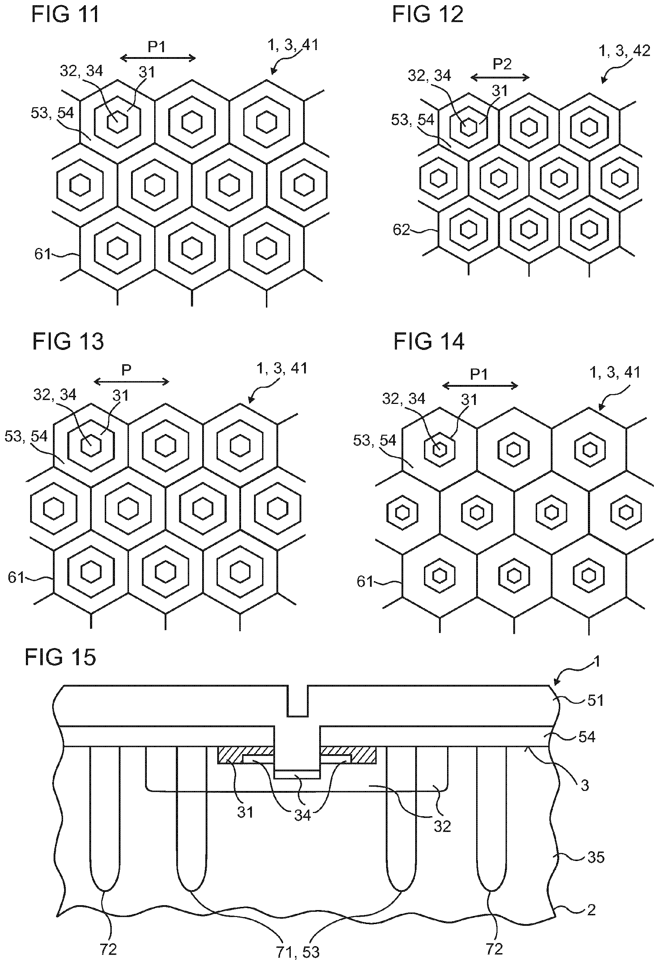

In the semiconductor devices 1 of Figures 5 to 10, there have been the arrangement lines 33. However, a design with emitter cells is also possible in the same manner, the Figures 11 to 14. In these Figures 11 to 14, exemplarily the emitter cells correspond to the first and second unit cells 61, 62, and are of hexagonal shape, seen in top view. However, other shapes are possible as well.

For example, optionally in each cell 61, 62 there is a central area in which the plug region 34 or alternatively directly the well region 32 can electrically be contacted by means of the first electrode 51, compare Figure 1 which applies to both the arrangement lines design and the cells design. Around said optional plug region 34, the source region 31 is located. Around the source region 31, the gate electrode 53 and the gate insulator 54 can be applied, for simplicity not shown in Figures 11 to 14. The optional plug regions 34 and/or the source regions 31 may all have the same basic shape of the respective emitter cell, like hexagonal, but other designs are also possible.

Thus, in Figures 11 and 12 it is drawn that the pitch P2 from a center point to an adjacent center point of the cells is larger in the pilot region 41 than in the mixed region 42. The occupancy proportion can be adjusted by having relatively small source regions 31 in the mixed region 42, for example.

Thus, analogously to Figures 7 and 8 or 9 and 10, in Figures 11 and 12 the pitch is varied, and the occupancy proportion is adapted accordingly.

Otherwise, the same as to Figures 1 to 10 may also apply to Figures 11 and 12, and vice versa.

In Figures 13 and 14 it is shown that the pitch P is the same in the regions 41, 42, but that the size of the source regions 31 has been changed corresponding to different occupancy proportions. Hence, Figures 13 to 14 correspond to Figures 5 and 6.

Mixtures of the embodiments of Figures 11 and 12 on the one hand and of Figures 13 and 14 on the other hand are possible as well.

Otherwise, the same as to Figures 1 to 12 may also apply to Figures 13 and 14, and vice versa.

The semiconductor device 1 of Figure 15 is a reverse conducting insulated gate bipolar transistor, RC-IGBTs, of a trench design. Thus, the gate electrode 53 may be placed in first trenches 71 running from the emitter side 3 into the semiconductor layer sequence 2 and terminating in the drift region 35. The first trenches 71 may run through the well region 32. The source regions 31 may be limited to an area between the two first trenches 71.

Optional, there can be second trenches 72 which can be of the same width and depth as the first trenches 71. For example, the second trenches 72 can accommodate an electrode material at a same electric potential as the first electrode 51. The second trenches 72 may be located outside the well region 32, for example.

All the above-stated variations of the pitch P, P1, P2, the occupancy proportion, the width W, W1, W2 and/or the emitter cell design, individually or in any combination, can analogously be applied to the trench design of Figure 15.

Otherwise, the same as to Figures 1 to 14 may also apply to Figure 15, and vice versa.

The components shown in the figures follow, unless indicated otherwise, exemplarily in the specified sequence directly one on top of the other. Components which are not in contact in the figures are exemplarily spaced apart from one another. If lines are drawn parallel to one another, the corresponding surfaces may be oriented in parallel with one another. Likewise, unless indicated otherwise, the positions of the drawn components relative to one another are correctly reproduced in the figures.

The invention described here is not restricted by the description on the basis of the exemplary embodiments. Rather, the invention encompasses any new feature and also any combination of features, which includes in particular any combination of features in the patent claims, even if this feature or this combination itself is not explicitly specified in the patent claims or exemplary embodiments.

### List of Reference Signs

- 1: semiconductor device
- 2: semiconductor layer sequence
- 3: emitter side
- 31: source region (n-conductive)
- 32: well region (p-conductive)
- 33: arrangement line
- 34: plug region
- 35: drift region
- 36: buffer region
- 4: collector side
- 41: pilot region (p-conductive)
- 42: mixed region
- 421: n-conductive first sub-region of the mixed region
- 422: p-conductive second sub-region of the mixed region
- 43: edge region
- 51: first electrode
- 52: second electrode
- 53: gate electrode
- 54: gate insulation
- 6: unit cell
- 61: first unit cell
- 62: second unit cell
- 71: first trench (gate electrode)
- 72: second trench
- 9: modified semiconductor device
- P: pitch
- W: width of the arrangement lines having the source regions

## Claims

1. A semiconductor device (1) comprising a semiconductor layer sequence (2) having an emitter side (3) and a collector side (4), wherein
- at the emitter side (3), the semiconductor layer sequence (2) comprises a plurality of source regions (31) of a first conductivity type and a plurality of well regions (32) of a second conductivity type different from the first conductivity type, each of the source regions (31) is embedded in one of the well regions (32),
- at the collector side (4), the semiconductor layer sequence (2) comprises a pilot region (41) which is uniformly of the second conductivity type and a mixed region (42) which comprises first sub-regions (421) of the first conductivity type and second sub-regions (422) of the second conductivity type and which surrounds the pilot region (41), and
- a first area occupancy of the emitter side (3) by the source regions (31) is larger in the pilot region (41) than in the mixed region (42) and/or a second area occupancy of the well regions (32) by the source regions (31) is smaller in the mixed region (42) than in the pilot region (41).

2. The semiconductor device (1) according to the preceding claim,
wherein the semiconductor device (1) is a bi-mode insulated gate transistor, BiGT.

3. The semiconductor device (1) according to any one of the preceding claims,
wherein a pitch (P) between adjacent ones of the source regions (31) is larger in the pilot region (41) than in the mixed region (42), seen in top view of the emitter side (3).

4. The semiconductor device (1) according to any one of the preceding claims,
wherein the emitter side (3) comprises a pattern composed of a repeatedly placed unit cell (6), the unit cell (6) comprises one or a plurality of the source regions (31),
wherein an occupancy proportion of the source regions (31) in the unit cell (6) is larger in the pilot region (41) than in the mixed region (42), seen in top view of the emitter side (3) .

5. The semiconductor device (1) according to any one of the preceding claims,
wherein at least one of the pitch (P) or the occupancy proportion differ between the pilot region (41) and the mixed region (42) by at least a factor of 1.2 and by at most a factor of 10.

6. The semiconductor device (1) according to any one of the preceding claims,
wherein the source regions (31) are arranged along a plurality of arrangement lines (33), seen in top view of the emitter side (3).

7. The semiconductor device (1) according to claims 4 and 6, wherein the unit cell (6) includes a portion of one or of a plurality of the arrangement lines (33).

8. The semiconductor device (1) according to any one of the two preceding claims,
wherein in the mixed region (42), seen in top view of the emitter side (3), the source regions (31) are placed at different locations along adjacent ones of the arrangement lines (33).

9. The semiconductor device (1) according to claim 4, wherein the emitter side (3) is structured into a plurality of emitter cells each comprising one of the source regions (31), and the emitter cells correspond to the unit cell (6).

10. The semiconductor device (1) according to any one of the preceding claims,
wherein in the pilot region (41) and in the mixed region (42) the pitch (P) between adjacent ones of the source regions (31) is the same, and
wherein in the pilot region (41) the occupancy proportion of the source regions (31) is larger than in the mixed region (42) .

11. The semiconductor device (1) according to any one of claims 1 to 9,
wherein in the pilot region (41) the pitch (P) between adjacent ones of the source regions (31) is by at least a factor of 1.2 larger than in the mixed region (42), and
wherein in the pilot region (41) the occupancy proportion of the source regions (31) is larger than in the mixed region (42) by at least a factor of 1.2.

12. The semiconductor device (1) according to any one of the preceding claims,
which is of a planar design so that a gate electrode (53) of the semiconductor device (1) is located on the emitter side (3) .

13. The semiconductor device (1) according to any one of claims 1 to 11,
which is of a trench design so that a gate electrode (53) of the semiconductor device (1) is arranged in trenches (7) extending from the emitter side (3) into the semiconductor layer sequence (2).

14. The semiconductor device (1) according to any one of the preceding claims,
wherein in the mixed region (42), seen in top view of the emitter side (3), there is no fixed correlation between the source regions (31) and the first sub-regions (421) as well as the second sub-regions (422).

15. The semiconductor device (1) according to any one of the preceding claims,
which is configured for a voltage between the emitter side (3) and the collector side (4) of at least 0.6 kV and of at most 10 kV.
